# EUROPÄISCHE PATENTSCHRIFT

(11) **EP 0 442 071 B1**
(45) Veröffentlichungstag und Bekanntmachung des Hinweises auf die Patenterteilung: **02.04.1997**
(21) Anmeldenummer: 90123765.1
(22) Anmeldetag: 11.12.1990
(51) Int. Cl.: G03F 7/027, G03F 7/00, G03F 7/004, G03F 7/40, G03C 9/08

(54) **Verfahren zur Herstellung photostrukturierter Schichten mit verbesserten mechanischen Eigenschaften**
Process for the production of photostructured layers with improved mechanical properties
Procédé pour la production de couches photostructurées avec de propriétés méchaniques améliorées

(30) Priorität: 15.02.1990 DE 4004620
(43) Veröffentlichungstag der Anmeldung: 21.08.1991
(73) Patentinhaber: DU PONT DE NEMOURS (DEUTSCHLAND) GMBH, 61352 Bad Homburg (DE); E.I. DU PONT DE NEMOURS AND COMPANY, Wilmington Delaware 19898 (US)
(72) Erfinder: Grossa, Mario, Dr., W-6072 Dreieich (DE)
(74) Vertreter: Patentanwälte Lippert, Stachow, Schmidt & Partner

(56) Entgegenhaltungen:
- FR-A- 2 028 302
- GB-A- 2 119 810

## Beschreibung

Gegenstand der vorliegenden Erfindung ist ein Verfahren zur Herstellung photostrukturierter Schichten und dreidimensionaler Objekte, bei dem eine oder mehrere Schichten eines lichtempfindlichen Gemischs aus einer sowohl photopolymerisierbaren wie auch thermisch härtbaren Plastisoldispersion bildmäßig belichtet und die nicht belichteten Bereiche entfernt werden und dann die photopolymerisierten Bereiche thermisch nachgehärtet werden.

Zur Herstellung strukturierter Schichten werden heute vielfach Verfahren angewendet, bei denen lichtempfindliche Schichten bildmäßig belichtet und anschließend die belichteten oder die nicht belichteten Bereiche z.B. durch Auswaschen entfernt werden. Besonders bei der Produktion von Druckplatten, Ätz- oder Galvanoresists und Lötstopmasken kommen sogenannte negativ arbeitende Gemische zum Einsatz, die unter Lichteinwirkung polymerisieren bzw. vernetzen (z.B. DE-C 22 15 090) und ggfs. thermisch nachgehärtet werden können (z.B. EP-B 00 73 444 und EP-B 00 63 304).

Diese Art der Photostrukturierung findet auch bei der Herstellung dreidimensionaler Objekte in zunehmendem Maße Verwendung. Verschiedene Verfahren, die dreidimensionale Modelle durch schrittweisen Aufbau vieler einzelner photogehärteter Schichten bilden, sind bekannt (US 4,575,330; EP-A 02 50 121; US 4,752,498 und J. Imaging Technol., 15 (4), 186-190 (1989) und die darin zitierte Literatur). In diesen Prozessen werden sowohl Techniken, die mit verschiedenen Belichtungsmasken für jede einzelne Schicht arbeiten, als auch solche, die direkt mit einem Laser die gewünschte Struktur in die polymersierbaren Schichten schreiben, genutzt. Die bisherigen Publikationen beschäftigen sich aber nicht mit speziellen lichtempfindlichen Gemischen für dreidimensionale Objekte, sondern nur mit der Verfahrenstechnik, wobei die für andere Produkte bekannten lichtempfindlichen Materialien verwendet werden.
Diese bestehen üblicherweise aus einem polymeren Bindemittel, einem flüssigen, photopolymersierbaren Monomer und einem Photoinitiator, wobei Zusätze wie Füllstoffe, Inhibitoren gegen thermische Polymerisation, Farbstoffe, etc. ebenfalls enthalten sein können. Mit diesen Gemischen hergestellte Materialien besitzen aber oft ungenügende mechanische Festigkeit. Auch ist die Verarbeitung von solchen polymerisierbaren Mischungen schwierig, da ihre Viskosität sehr hoch ist. Zur Erniedrigung der Viskosität werden üblicherweise Weichmacher zugesetzt. Diese haben jedoch den Nachteil, daß sie aus den fertigen Materialien leicht ausschwitzen.

Eine spezielle Art von Polymer/Weichmacher-Mischungen sind Plastisole oder Organosole. Dies sind 40 - 80 Gew.%ige Dispersionen von Polymeren in flüssigen, nicht flüchtigen Weichmachern, die beim Erhitzen der Dispersion über eine bestimmte Temperatur (Gelier- oder Plastisoltemperatur) die Polymere zu lösen vermögen. Beim Abkühlen dieser Phase auf Raumtemperatur entstehen dann feste, transparente Materialien. Auch flüchtige Lösungsmittel können diesen Dispersionen zugesetzt werden. Liegt deren Gehalt unter 10 Gew.% spricht man von Plastisolen, bei höherem Lösungsmittelgehalt von Organosolen.

Plastisole, denen Monomere und Photoinitiatoren oder thermische Initiatoren zugesetzt werden und die somit im Anschluß an die thermische Polymer/Weichmacher-Verschmelzung nachgehärtet werden können, sind bekannt. Solche reaktiven Plastisole werden z.B. in den Patentschriften US 2,618,621; DE-A 30 06 349; US 4,523,983 oder US 4,623,558 beschrieben. Mischungen aus einem Plastisol, einem polyfunktionellen Monomer und/oder einem Epoxyharz, einem Photoinitiator und einem thermischen Initiator, die als Dichtmassen und Kleber verwendet werden können, sind in J. Radiat. Curing, 10 (4), 8 - 11 (1983) und DE-A 33 14 896 beschrieben. Diese Plastisolmischungen werden verfestigt, indem sie durch eine kurze Vollbelichtung fixiert (wie es auch in US 4,634,562 für Gemische ohne thermischen Initiator beschrieben wird) und anschließend durch thermische Behandlung vollständig gehärtet werden. Die thermische Polymerisation wird hier dazu ausgenutzt, den Kleber dort zu härten, wo eine Photopolymerisation nicht möglich ist. Bei dem Verfahren zur Druckplattenherstellung gemäß US 4,176,028 werden Plastisole verwendet, die lediglich photohärtbar sind und deren thermische Verschmelzung zur Ausbildung einer photopolymerisierbaren Schicht ausgenutzt wird. Diese wird dann auf das Trägermaterial auflaminiert und dann nach dem üblichen Verfahren bildmäßig belichtet und ausgewaschen. Hierbei dürfen natürlich keine Plastisole verwendet werden, die thermische Initiatoren enthalten und so bei der Ausbildung der photopolymerisierbaren Schichten sehr harte Schichten bilden, da sonst das Entfernen der unbelichteten Bereiche beeinträchtigt wird.

Ein anderes Verfahren zur Herstellung von Druckplatten, das die Kombination Plastisol und photopolymerisierbares Gemisch verwendet, wird beschrieben in US 3,615,448 und W. J. Nebe in Symposium Photopolymer Systems Washington 1978, Adv. Printing of Summaries, S. 75-56. Hierbei wird eine Schicht die aus einem Plastisol, einer lichtempfindlichen Verbindung wie ein Monomer, ein vernetzbares Polymer oder ein polymerisierbarer Weichmacher und einem Photoinitiator besteht, bildmäßig belichtet und dann erhitzt. Dabei verschmelzen die nicht belichteten Bereiche und bilden beim Abkühlen feste, nicht klebrige Bereiche. Die belichteten Teile können dann ausgewaschen oder getont werden. Plastisolverschmelzung und Photohärtung treten bei diesem Verfahren in verschiedenen Bereichen auf, wobei bildmäßig zwischen den thermisch verschmelzbaren und nicht verschmelzbaren Bereichen durch die Photopolymerisation der Monomere, Polymere oder Weichmacher differenziert wird.

Die Aufgabe der vorliegenden Erfindung ist es, ein Verfahren anzugeben, mit dem ausgehend von einem lichtempfindlichen Gemisch strukturierte Schichten oder dreidimensionale Objekte hergestellt werden können, die eine hohe mechanische Beständigkeit aufweisen. Sie sollten hohe Reißfestigkeit, große Shore Härte, geringe Dehnbarkeit, hohe Steifigkeit und geringe Schrumpfung als Folge des Härtungsprozesses aufweisen. Zudem sollte keine Weichmacherwanderung erfolgen und die lichtempfindlichen Gemische sollten gut handhabbar und leicht zu verarbeiten sein. Gleichzeitig soll eine exakte Wiedergabe der darzustellenden Bilder oder Modelle gewährleistet sein. Diese Aufgabe wird gelöst durch ein Verfahren zur Herstellung photostrukturierter Schichten umfassend
a) Ausbilden einer Schicht aus einem lichtempfindlichen Gemisch enthaltend
   1. eine thermisch verschmelzbare Polymer/Weichmacher-Dispersion,
   2. mindestens eine additionspolymerisierbare, ethylenisch ungesättigte Verbindung,
   3. einen Photoinitiator oder ein Photoinitiatorsystem und
   4. eine thermisch reaktive Verbindung,
b) bildmäßiges Belichten der gemäß a) hergestellten lichtempfindlichen Schicht,
c) Entfernen der unbelichteten Bereiche und
d) thermisches Nachbehandeln.

Die Herstellung dreidimensionaler Objekte erfolgt durch ein Verfahren gemäß Anspruch 2.

Mit dem vorliegenden Verfahren ist es möglich, die Vorteile reaktiver Plastisole für die bildmäßige Photostrukturierung nutzbar zu machen. Keines der bekannten Verfahren zur Verarbeitung reaktiver Plastisole legt das erfindungsgemäße Verfahren nahe. Es ist überraschend, daß weder bei der bildmäßigen Belichtung und dem Entfernen der unbelichteten Bereiche noch bei der thermischen Verschmelzung oder der thermischen Härtung nachteilige Effekte auftreten. Es war vor allen Dingen nicht zu erwarten, daß trotz vorausgehender Photopolymerisation die thermische Verschmelzung noch möglich ist, obwohl aus dem Stand der Technik bekannt ist, daß gerade durch bildmäßige Belichtung von Plastisolen, die Monomere und Photoinitiatoren enthalten, zwischen thermisch verschmelzbaren und nicht verschmelzbaren Bereichen differenziert werden kann.

Erfindungswesentlich ist die Verwendung eines lichtempfindlichen Gemischs, das sowohl photopolymerisierbar wie auch thermisch verschmelzbar und härtbar ist. Als Bindemittelsystem des erfindungsgemäßen lichtempfindlichen Gemischs wird eine Polymer/Weichmacher-Dispersion verwendet, die beim Erhitzen zu einer Phase verschmilzt, welche beim Abkühlen zu einer festen, transparenten Masse erhärtet. Gleichzeitig bedingt der aufgrund der Verwendung eines Plastisols hohe Weichmacheranteil eine geringe Viskosität und damit eine gute Verarbeitbarkeit des lichtempfindlichen Gemischs. Die Kombination eines Monomers bzw. einer Monomermischung mit einem Photoinitiator und einer thermisch reaktiven Verbindung bedingt die Möglichkeit der bildmäßigen Photopolymerisierung und der anschließenden thermischen Nachhärtung. Überraschenderweise wurde durch den Zusatz einer thermisch reaktiven Verbindung die Stabilität und Handhabbarkeit des lichtempfindlichen Gemischs nicht wesentlich beeinträchtigt, obwohl üblichen lichtempfindlichen Gemischen Inhibitoren gegen eine thermische Polymerisation zugesetzt werden müssen. Überraschend war auch, daß die Festigkeit der strukturierten Materialien bei kurzen Belichtungszeiten am höchsten war

Ein wesentlicher Punkt des erfindungsgemäßen Verfahren ist, daß die thermische Behandlung erst nach dem Entfernen der nicht belichteten Bereiche erfolgt.

Die thermische Behandlung erstreckt sich demnach nur auf die belichteten Bereiche, deren mechanische Eigenschaften dadurch wesentlich verbessert werden können. Die Stabilisierung der durch bildmäßige Photopolymerisation strukturierten Materialien wird zwar zum Teil durch die Plastisolverschmelzung des Bindemittelsystems bewirkt, aber eine weitergehende Verstärkung erfolgt erst durch eine zusätzliche thermisch Härtung. Strukturierte Materialien, die durch eine thermische Behandlung diese zweifache Verstärkung erfahren haben, besitzen eine ausreichende mechanische Festigkeit und Widerstandsfähigkeit gegenüber starker Belastung und weisen zudem eine hohe Lebensdauer auf. Ein strukturiertes Material, das lediglich durch die Plastisolverschmelzung gehärtet wurde, weist niedrigere Zugfestigkeit, höhere Dehnung und Weichmacherwanderung auf.

Für die erfindungswesentliche thermische Härtung enthält das lichtempfindliche Gemisch bevorzugt einen thermischen Initiator und eine additionspolymersierbare, ethylenisch ungesättigte Verbindung. Diese kann das für die Photopolymerisation verwendete Monomer bzw. eine Monomermischung sein, welche im Photopolymerisationsschritt nicht vollständig umgesetzt wurde. Dies kann erreicht werden durch kurze Belichtungszeiten, Beschränkung der Photoinitiierung durch Wahl einer hohen optischen Dichte, bevorzugt D ≧ 1,3, oder Beimengen von weniger reaktiven Monomeren. Bevorzugt werden Monomermischungen verwendet, die Monomere unterschiedlicher Reaktivität enthalten. Das reaktivere Monomer wird bei der bildmäßigen Belichtung zur Strukturierung des Materials photopolymerisiert, und das Monomer mit der geringeren Reaktivität wird während der Nachbehandlung zur Verstärkung des Materials thermisch polymerisiert. Zudem müssen die Monomere mit den Polymeren verträglich sein. Vor allem das weniger reaktive Monomer muß besonders bei erhöhter Temperatur mit dem Polymeren kompatibel sein. Andererseits dürfen die Monomere das Polymer bei Raumtemperatur nicht quellen. Geeignete Monomere mit unterschiedlicher Reaktivität sind z.B. Acrylate und Methacrylate. Folgende Monomere sind z.B. geeignet: Ethylacrylat und -methacrylat, 1,4-Butandioldiacrylat und -methacrylat, Isodecylacrylat und -methacrylat, Dicyclopentenyldiacrylat und -methacrylat, 2-Ethylhexylacrylat und -methacrylat, Laurylacrylat und -methacrylat. Besonders vorteilhaft sind Trimethylolpropantriacrylat und -methacrylat bzw. 1,6-Hexandiolacrylat und -methacrylat oder ethoxyliertes Trimethylolpropantriacrylat und N-Vinylpyrrolidon. Die thermische Polymerisation darf nicht unterhalb der Plastisoltemperatur erfolgen, sondern bei, bevorzugt aber oberhalb, dieser Temperatur. D.h. die thermische Polymerisation soll erst nach der Plastisolverschmelzung innerhalb der dadurch gebildeten Phase stattfinden. Dies wird dadurch erreicht, daß ein thermischer Initiator verwendet wird, der bei, oder bevorzugt oberhalb der Plastisoltemperatur zerfällt. Geeignete thermische Initiatoren sind beispielsweise t-Butylhydroperoxid, t-Butylperbenzoat, Cumolhydroperoxid.

Eine weitere Ausgestaltung der Erfindung umfaßt die thermische Härtung mittels Verbindungen, die mit sich selbst und/oder mit einer oder mehreren anderen Komponenten des Gemischs thermisch vernetzbar sind. Hierfür eignen sich z.B. Verbindungen mit Epoxy-, Hydroxy-, Alkylether-, Acyl- und Hydroxyalkylgruppen. Besonders geeignet sind Verbindungen mit mindestens zwei Epoxygruppen und Melaminderivate. Bevorzugt werden Hexamethoxy-melamin, 3,4-Epoxycyclohexylcarbonsäure-3,4-epoxycyclohexylmethylester und 2,2-Bis(glycidoxy-phenyl)propan verwendet.

Als Photopolymerisationinitiatoren kommen die an sich bekannten Photoinitiatoren bzw. Initiatorsysteme in Betracht wie z.B. Benzoin, Benzoinalkylether, α-Methylbenzoin bzw. dessen Ether, Benzildimethylketal und Systeme wie z.B. Benzophenon/Michlers Keton und Thioxanthone/Amine. Erfindungsgemäß werden Polymer/Weichmacher-Dispersionen, die bei Temperaturerhöhung verschmelzen, als Bindemittelsystem verwendet. Geeignet sind Plastisole und Organosole mit 40 bis 80 Gew.%, bevorzugt 50 bis 70 Gew.%, eines Homo- oder Copolymeren des Vinylchlorid, Vinylacetat, Vinylpropionat, Vinylstearat, Vinylether, Vinylpyridin, Styrol, Acrylsäure und Methacrylsäure bzw. deren Ester wie z.B. Methyl(meth)acrylat, Ethyl(meth)acrylat, Butyl(meth)acrylat, Octyl(meth)acrylat, (Meth)acrylnitril, etc. Auch Mischungen aus mehreren der genannten Homo- oder Copolymere oder Polymere vom Core/Shell-Typ können verwendet werden. Das Molekulargewicht der Polymere sollte zwischen 10 000 und 200 000, bevorzugt zwischen 50 000 und 180 000, liegen. Besonders geeignet sind Polymere mit einem Molekulargewicht zwischen 70 000 und 150 000.

Als Weichmacher, die 20 bis 60 Gew.%, bevorzugt 30 bis 50 Gew.% der Plastisoldispersionen ausmachen, eignen sich z.B. Phosphate, Phthalate, Sebacinsäure- oder Adipinsäureester. Besonders geeignet sind Dibutylphthalat, Diisodecylphthalat, Butylbenzylphthalat, Trikresylphosphat, Tributylphosphat, insbesondere Diethylhexylphthalat und Triethylenglyoldiacetat. Auch thermisch polymerisierbare Weichmacher wie Triallylphosphat und Diallylphthalat können verwendet werden.

Die erfindungsgemäßen lichtempfindlichen Gemische enthalten üblicherweise 40 bis 90 Gew.% des Bindemittelsystems, 5 bis 30 Gew.% Monomer, 0,01 bis 5 Gew.% Photoinitiator und 0,1 bis 5, bevorzugt 0,5 bis 2, Gew.% eines thermischen Initiators oder 1 bis 30, bevorzugt 10 bis 20, Gew.% einer mit sich selbst und/oder mit einer oder mehreren anderen Komponenten des Gemischs thermisch vernetzbaren Verbindung.

Desweiteren können übliche Zusätze wie z.B. Verdickungsmittel wie SiO₂, Füller, Farbstoffe, Stabilisatoren in dem lichtempfindlichen Gemisch enthalten sein. Besonders vorteilhaft ist der Zusatz von Verbindungen, die beim Erhitzen auf die Plastisoltemperatur Wasser, CO_{2,} N₂, etc. freisetzen wie z.B. Kaliumhydrogencarbonat. Hierdurch kann die bei der Härtung in der Regel auftretende Schrumpfung verringert werden. Das vorliegende Verfahren zur Herstellung strukturierter Schichten umfaßt die Ausbildung einer Schicht des erfindungswesentlichen, lichtempfindlichen Gemischs, ggfs. auf einem Träger, die bildmäßige Belichtung dieser Schicht, das Entfernen der unbelichteten Bereiche und die thermische Nachbehandlung. Geeignete Trägermaterialien sind z.B. Glas, metallische Träger, metallkaschierte Träger und Kunststoffolien wie z.B. Polyester.

Das Aufbringen des lichtempfindlichen Gemischs auf das Trägermaterial kann durch die gängigen Beschichtungsmethoden wie beispielsweise Gießen, Tauchen, Sprühen, etc. erfolgen. Die Schichtdicke beträgt gewöhnlich 2 bis 750 µm, bevorzugt 25 bis 400 µm. Die zur bildmäßigen Belichtung benötigte aktinische Strahlung kann UV-, sichtbares oder IR-Licht sein, bevorzugt wird UV-Licht verwendet. Die Belichtung wird z.B. mit Quecksilberdampflampen, Xenonlampen oder Kohlelichtbogenlampen vorgenommen. Besonders vorteilhaft ist die Verwendung von Lasern. Nicht photopolymerisierte Bereiche können durch einen Luftstrom oder durch Behandeln mit flüssigen oder dampfförmigen Lösungsmitteln entfernt werden. Falls erforderlich kann mit einem geeigneten Lösungsmittel wie z.B. Trichlorethan nachgewaschen werden. Das Entfernen der nicht photopolymerisierten Bereiche kann auch direkt durch Auswaschen mit einem der üblichen Entwicklungslösungsmittel erfolgen. Anschließend erfolgt die thermische Nachhärtung in einem Elektroofen oder mittels einer IR-Lampe. Die Temperatur sollte 80 bis 200° C, bevorzugt 100 bis 180° C betragen. Die Dauer der thermischen Behandlung richtet sich nach dem verwendeten lichtempfindlichen Gemisch und liegt zwischen 15 und 60 Minuten.

Die erfindungswesentlichen, lichtempfindlichen Gemische werden bevorzugt zur Herstellung dreidimensionaler Objekte verwendet. Besonders geeignet sind sie zum schichtweisen Aufbau dieser Objekte, wobei die einzelnen Schichten der lichtempfindlichen Gemische übereinander aufgetragen und einzeln bildweise belichtet werden. Hierfür ist insbesondere die Verwendung von Laserstrahlen zum direkten Beschreiben der lichtempfindlichen Schichten vorteilhaft wie sie z.B. in US 4,575,330 oder EP-A 02 50 121 beschrieben wird. Die Ausbildung der einzelnen Schichten des lichtempfindlichen Gemischs kann nach verschiedenen üblichen Methoden erfolgen, bei denen das lichtempfindliche Gemisch schrittweise zur Herstellung der jeweiligen Schicht zugegeben wird. Es ist aber auch möglich, das gesamte lichtempfindliche Gemisch in einen Behälter zu geben, der eine vertikal bewegliche Trägerplatte enthält. Zu Beginn des Verfahrens befindet sich diese Trägerplatte an der Oberfläche des lichtempfindlichen Gemischs und ist mit einer Schicht dieses Gemischs bedeckt. Diese Schicht wird bildmäßig belichtet. Anschließend wird die Trägerplatte abgesenkt, so daß sich eine neue, lichtempfindliche Schicht ergibt. Die neugebildete lichtempfindliche Schicht wird dann auch bildmäßig belichtet. Diese Verfahrensschritte werden so oft wiederholt, bis das dreidimensionale Objekt fertig aufgebaut ist. Die weitere Behandlung erfolgt wie beim einschichtigen Verfahren.

### Beispiel 1

Eine Dispersion A aus 10 g Polyvinylchlorid (MG 110 000), 5 g Bis-(2-ethylhexyl-)phthalat, 3 g Trimethylolpropantriacrylat, 3 g Hexandioldiacrylat, 0,5 g Benzildimethylketal und 0,2 g Dibenzoylperoxid wurde in einer Schichtdicke von 0,3 mm auf eine Kupferplatte aufgebracht und mit einem durch einen Rasterscanner gesteuerten Argonlaser (360 nm, 250 mJ/cm²) einem Schaltungsmuster entsprechend belichtet. Die unbelichteten Anteile wurden durch Abspülen mit einem Gemisch aus Ethanol und Trichlorethan (1:1) entfernt. Anschließend wurde die so strukturierte Schicht 5 min auf 180° C erhitzt. Man erhielt so eine exakte Wiedergabe der Schaltungsvorlage.

### Beispiel 2

Dispersion A und eine Dispersion B (wie A nur ohne Dibenzoylperoxid) wurden in einer Schichtdicke von 0,3 mm mit einem Argonlaser (360 nm, 250 mJ/cm²) vollflächig belichtet und anschließend 5 min auf 180° C erhitzt. Die Zugfestigkeit F und die Ausdehnung L wurden mit einem Zwick Gerät 1435 gemessen.

| | F [N/mm²] | L [%] |
|---|---|---|
| Dispersion A | 43 | 6 |
| Dispersion B | 31 | 10 |

### Beispiel 3

Zwei Muster der Dispersion A wurden in einer Schichtdicke von 0,3 mm mit einem Argonlaser (360 nm) belichtet. Die Belichtungsenergie betrug:
a) 50 mJ/cm²
b) 500 mJ/cm²
Anschließend wurden die Schichten 3 min auf 180° C erhitzt. Die Zugfestigkeit der Proben wurde wie in Beispiel 2 bestimmt:
a) 49 N/mm²
b) 40 N/mm²
Der Versuch zeigt, daß zur Erhöhung der Festigkeit eine diffusionsfähige Restmenge an Monomer vor der thermischen Behandlung vorhanden sein muß.

### Beispiel 4

Eine Dispersion aus 10 g pulverförmigem Polymethylmethacrylat (MG 150 000), 4 g ethoxyliertes Trimethylolpropantriacrylat, 5,5 g Dimethylphthalat, 2 g N-Vinylpyrrolidon, 0,4 g Benzildimethylketal und 0,2 g 2,2-Azo-bis-isobuttersäurenitril wurde auf eine Kupferplatte in einer Schichtdicke von 0,4 mm aufgetragen und mit einem durch einen Rasterscanner gesteuerten Argonlaser (360 nm, 60 mJ/cm²) einem Schaltungsmuster entsprechend belichtet. Die unbelichteten Bereiche wurden mit einer Mischung von 1,1,1-Trichlorethan und Ethanol ausgewaschen. Anschließend wurde 5 min auf 140° C erhitzt. Man erhielt eine exakte Wiedergabe der Schaltungsvorlage.

### Beispiel 5

Zur Herstellung eines würfelförmigem Objekts der Kantenlänge 1,5 cm wurde die Dispersion des Beispiels 4 in einen Behälter gegeben, in dem sich eine vertikal bewegliche Trägerplatte befand. Zu Beginn des Verfahrens befand sich diese Trägerplatte in einer solchen Position, daß sie mit einer Schicht der Dispersion bedeckt war. Diese Schicht wurde mit einem Argonlaser bei etwa 360 nm entsprechend einem Quadrat belichtet. Der Durchmesser des Laserstrahl betrug 150 µm. Gesteuert wurde der Laser über einen Rasterscanner. Die Belichtungsenergie pro Fläche betrug 90 mJ/cm². Nach dem Belichten der ersten Schicht wurde die Trägerplatte soweit abgesenkt, daß sich eine neue Schicht der lichtempfindlichen Dispersion bildete. Diese Schicht wurde wieder mit dem Laser belichtet. Diese Verfahrensschritte wurden so oft wiederholt, bis das würfelförmige Objekt fertig aufgebaut war. Insgesamt wurden 50 Schichten verwendet. Die Schichtdicke betrug jeweils 300 µm. Das photopolymerisierte Objekt wurde aus dem Behälter genommen, die restliche, nicht photopolymerisierte Dispersion durch einen Luftstrom entfernt und das würfelförmige Objekt 10 min auf 140° C erhitzt. Man erhielt ein festes, flexibles Objekt, das eine exakte Wiedergabe der Vorlage war.

### Beispiel 6

Eine Dispersion aus 30 g Polyvinylchlorid (MG 110 000), 16 g Bis-(2-ethylhexyl)phthalat, 9 g 7,7,9-Trimethyl-4,13-dioxo-3,14-dioxa-5,12-diaza-hexadecan-1,16-diol-dimethacrylat, 9 g N-Ninylpyrrolidon (10 ppm N,N -Di-sek-butyl-p-phenylendiamin), 3 g Benzildimethylketal und 15 g 3,4-Epoxycyclohexancarbonsäure-3,4-epoxycyclohexylmethylester wurde in einer Schichtdicke von 0,3 mm auf eine Kupferplatte aufgebracht und mit einem durch einen Rasterscanner gesteuerten Argonlaser (360 nm, 250 mJ/cm²) einem Schaltungsmuster entsprechend belichtet. Die unbelichteten Anteile wurden mit dampfförmigem Trichlorethan entfernt. Anschließend wurde die so strukturierte Schicht 5 min auf 150° C erhitzt. Man erhielt so eine exakte Wiedergabe der Schaltungsvorlage.

## Patentansprüche

1. Verfahren zur Herstellung photostrukturierter Schichten umfassend
a) Ausbilden einer Schicht aus einem lichtempfindlichen Gemisch enthaltend
1. eine thermisch verschmelzbare Polymer/Weichmacher-Dispersion,
2. mindestens eine additionspolymerisierbare, ethylenisch ungesättigte Verbindung,
3. einen Photoinitiator oder ein Photoinitiatorsystem und
4. eine thermisch reaktive Verbindung,
b) bildmäßiges Belichten der gemäß a) hergestellten lichtempfindlichen Schicht,
c) Entfernen der unbelichteten Bereiche und
d) thermisches Nachbehandeln.

2. Verfahren zur Herstellung dreidimensionaler Objekte umfassend
a) Ausbilden einer Schicht aus einem lichtempfindlichen Gemisch enthaltend
1. eine thermisch verschmelzbare Polymer/Weichmacher-Dispersion,
2. mindestens eine additionspolymerisierbare, ethylenisch ungesättigte Verbindung,
3. einen Photoinitiator oder ein Photoinitiatorsystem und
4. eine thermisch reaktive Verbindung,
b) bildmäßiges Belichten der gemäß a) hergestellten lichtempfindlichen Schicht,
c) Auftragen einer neuen Schicht des lichtempfindlichen Gemischs auf die gemäß b) belichtete Schicht,
d) bildmäßiges Belichten der gemäß c) hergestellten lichtempfindlichen Schicht,
e) fortlaufendes Wiederholen der Schritte c) und d) bis das dreidimensionale Objekt vollständig aufgebaut ist,
f) Entfernen der nicht belichteten Bereiche und
g) thermisches Nachbehandeln.

3. Verfahren nach Anspruch 1 oder 2
dadurch gekennzeichnet, daß
die thermisch reaktive Verbindung ein thermischer Initiator ist.

4. Verfahren nach Anspruch 1 bis 3
dadurch gekennzeichnet, daß
die bildmäßige Belichtung bei einer Wellenlänge erfolgt, wo die optische Dichte der zu belichtenden Schicht ≥ 1,3 ist.

5. Verfahren nach Anspruch 1 bis 4
dadurch gekennzeichnet, daß
mindestens zwei additionspolymerisierbare, ethylenisch ungesättigte Verbindungen unterschiedlicher Reaktivität verwendet werden.

6. Verfahren nach Anspruch 1 bis 5,
dadurch gekennzeichnet, daß
der thermische Initiator bei oder oberhalb der Temperatur, bei der die Polymer/Weichmacher-Dispersion verschmilzt zerfällt.

7. Verfahren nach Anspruch 1 oder 2
dadurch gekennzeichnet, daß
die thermisch reaktive Verbindung eine mit sich selbst und/oder mit einer oder mehreren anderen Komponente des Gemischs thermisch vernetzbare Verbindung ist.

8. Verfahren nach Anspruch 1, 2 oder 7
dadurch gekennzeichnet, daß
die thermisch reaktive Verbindung eine Epoxy- oder eine Melaminverbindung ist.

9. Verfahren nach Anspruch 1 bis 8,
dadurch gekennzeichnet, daß
die Polymer/Weichmacher-Dispersion ein Plastisol oder Organosol ist.

10. Verfahren nach Anspruch 1 bis 9,
dadurch gekennzeichnet, daß
das lichtempfindliche Gemisch mindestens eine Verbindung enthält, die bei erhöhter Temperatur Gase freisetzt.

## Claims

1. Process for the preparation of photostructured layers, comprising:
a) formation of a layer of a light-sensitive mixture containing
1. a thermally fusible polymer/plasticizer dispersion,
2. at least one addition-polymerizable, ethylenically unsaturated compound,
3. a photoinitiator or a photoinitiator system, and
4. a thermally reactive compound,
b) imagewise exposure of the light-sensitve layer produced in accordance with a),
c) remove of the unexposed areas, and
d) thermal after treatment.

2. Process for the preparation of three-dimensional objects, comprising:
a) formation of a layer of a light-sensitive mixture containing
1. a thermally fusible polymer/plasticizer dispersion,
2. at least one addition-polymerizable, ethylenically unsaturated compound,
3. a photoinitiator or a photoinitiator system, and
4. a thermally reactive compound,
b) imagewise exposure of the light-sensitve layer produced in accordance with a),
c) apply of a new layer of the light-sensitive mixture onto the layer exposed in accordance with b),
d) imagewise exposure of the light-sensitive layer produced in accordance with c),
e) succesive repeat of steps c) and d) until the three-dimensional object is fully formed,
f) remove of the unexposed areas, and
g) thermal after treatment.

3. Process according to claims 1 or 2,
characterized in that,
the thermally reactive compound is a thermal initiator.

4. Process according to claims 1 to 3,
characterized in that,
the imagewise exposure is accomplished at a wavelength where the optical density of the layer being exposed is ≥ 1.3.

5. Process according to claims 1 to 4,
characterized in that,
at least two addition-polymerizable, ethylenically unsaturated compounds of different reactivities are used.

6. Process according to claims 1 to 5,
characterized in that,
the thermal initiator decomposes at or above the temperature at which the polymer/plasticizer dispersion melts.

7. Process according to claims 1 or 2
characterized in that,
the thermally reactive compound is a compound thermally crosslinkable with itself and/or with one or more components of the mixture.

8. Process according to claims 1, 2 or 7,
characterized in that
the thermally reactive compound is an epoxy or a melamine compound.

9. Process according to claims 1 to 8,
characterized in that,
the polymer/plasticizer dispersion is a plastisol or an organosol.

10. Process according to claims 1 to 9,
characterized in that
the light-sensitive mixture contains at least one compound that releases a gas at an elevated temperature.

## Revendications

1. Procédé de fabrication de couches photostructurées comprenant les étapes suivantes:
a) Formation d'une couche à partir d'un mélange sensible à la lumière contenant:
1. une dispersion de polymère/plastifiant thermiquement fusible;
2. au moins un dérivé à insaturation éthylénique polymérisable par addition;
3. un photoinitiateur ou un système de photoinitiateur et
4. un dérivé thermiquement réactif,
b) Exposition à la façon dont on forme une image de la couche photosensible préparée selon (a),
c) Elimination des zones non exposées et
d) Traitement thermique ultérieur.

2. Procédé de fabrication d'objets tridimensionnels comprenant les étapes suivantes:
a) formation d'une couche d'un mélange photosensible contenant:
1. une dispersion de polymère/plastifiant thermiquement fusible;
2. au moins un dérivé à insaturation éthylénique polymérisable par addition;
3. un photoinitiateur ou un système de photoinitiateur et
4. un dérivé thermiquement réactif,
b) exposition à la façon dont on forme une image de la couche photosensible préparée selon (a);
c) application d'une nouvelle couche du mélange photosensible sur la couche exposée selon (b);
d) exposition à la façon dont on forme une image de la couche photosensible préparée selon (c),
e) répétition des étapes c) et d) poursuivie jusqu'à ce que l'objet tridimensionnel soit totalement achevé,
f) élimination des zones non-exposées et
g) traitement thermique ultérieur.

3. Procédé de fabrication de couches photostructurées selon la revendication 1 ou 2, caractérisé en ce que le dérivé thermiquement réactif est un initiateur thermique.

4. Procédé de fabrication de couches photostructurées selon les revendications 1 à 3, caractérisé en ce que l'exposition à la façon dont on forme une image se fait à une longueur d'onde pour laquelle la densité optique de la couche à exposer est supérieure ou égale à 1,3.

5. Procédé de fabrication de couches photostructurées selon les revendications 1 à 4, caractérisé en ce que l'on emploie au moins deux dérivés insaturés éthyléniquement polymérisables par addition présentant des réactivités différentes.

6. Procédé de fabrication de couches photostructurées selon les revendications 1 à 5, caractérisé en ce que l'initiateur thermique se décompose à une température égale ou supérieure à celle à laquelle fond la dispersion polymère/plastifiant.

7. Procédé de fabrication de couches photostructurées selon la revendication 1 ou 2, caractérisé en ce que le dérivé thermiquement réactif est un dérivé thermiquement réticulable avec lui-même et/ou avec un ou plusieurs composants du mélange.

8. Procédé de fabrication de couches photostructurées selon l'une quelconque des revendications 1, 2 ou 7, caractérisé en ce que le dérivé thermiquement réactif est un dérivé époxy ou un dérivé mélamine.

9. Procédé de fabrication de couches photostructurées selon les revendications 1 à 8, caractérisé en ce que la dispersion polymère/plastifiant est un plastisol ou un organosol.

10. Procédé de fabrication de couches photostructurées selon les revendications 1 à 9, caractérisé en ce que le mélange photosensible contient au moins un dérivé qui, à température élevée, libère des gaz.
